# EUROPEAN PATENT APPLICATION

(11) **EP 1 324 133 A1**
(43) Date of publication of application: **02.07.2003**
(21) Application number: 02258916.2
(22) Date of filing: 20.12.2002
(51) Int. Cl.: G03F 7/004, G03F 7/039

(54) **Photoresist compositions for short wavelength imaging**

(30) Priority: 31.12.2001 US 346027 P
(71) Applicant: Shipley Co. L.L.C., Marlborough, MA 01752 (US)
(72) Inventor: Adams, Timothy G., Sudbury, Massachusetts 01776 (US); Barclay, George G., Jefferson, Massachusetts 10522 (US)
(74) Representative: Kent, Venetia Katherine

(57) **Abstract**

New photoresists are provided that are suitable for short wavelength imaging, including sub-200 nm, particularly 193 nm. Resists of the invention contain a polymer that comprises fluoro substitution and alicyclic leaving groups, such may be provided by polymerization of an alkyl acrylate compound.

## Description

### BACKGROUND OF THE INVENTION

### 1. Field of the Invention

The present invention relates to new photoresists that are particularly suitable for short wavelength imaging, including sub-200 nm such as 193nm and 157 nm. More particularly, resists of the invention contain a polymer that comprises fluoro substitution and a photoacid-labile group that contains an alicyclic moiety.

### 2. Background

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble. Photoresist compositions are described in Deforest, Photoresist Materials and Processes, McGraw Hill Book Company, New York, ch. 2, 1975 and by Moreau, Semiconductor Lithography, Principles, Practices and Materials, Plenum Press, New York, ch. 2 and 4.

While currently available photoresists are suitable for many applications, current resists also can exhibit significant shortcomings, particularly in high performance applications such as formation of highly resolved sub-half micron and sub-quarter micron features.

Consequently, interest has increased in photoresists that can be photoimaged with short wavelength radiation, including exposure radiation of about 250 nm or less, or even about 200 nm or less, such as wavelengths of about 193 nm. Use of such short exposure wavelengths can enable formation of smaller features. Accordingly, a photoresist that yields well-resolved images upon 248 nm or 193 nm exposure could enable formation of extremely small (e.g. sub-0.25 µm) features that respond to constant industry demands for smaller dimension circuit patterns, e.g. to provide greater circuit density and enhanced device performance.

Quite recently, F₂ excimer laser imaging, i.e. radiation having a wavelength of about 157 nm, has been considered as a route to manufacture of even smaller features. See, generally, Kunz et al., SPIE Proceedings (Advances in Resist Technology), vol. 3678, pages 13-23 (1999).

### SUMMARY OF THE INVENTION

We now provide new photoresist compositions that comprise one or more photoacid generator compounds and a polymer that contains fluorine substitution and an alicyclic leaving group. Preferred resists of the invention are chemically-amplified positive-acting compositions that contain a component that comprises one or more photoacid-labile groups.

In a first aspect of the invention, resist polymers contain a photoacid-labile group that contains an alicyclic moiety. Preferably, the alicyclic moiety is a component of the leaving group of the resist polymer, i.e. the alicyclic moiety (alicyclic leaving group) is cleaved from the polymer structure as a consequence of the photoacid and other lithographic processing, particularly a post-exposure thermal treatment.

The invention also provides resist compositions that comprise a polymer having polymerized acrylate units, wherein the acrylate units comprise an alicyclic moiety. The alicyclic group typically is cleaved from the polymer during lithographic processing, i.e. upon exposure to photogenerated acid and subsequent thermal treatment. Preferred polymer comprise polymerized alkyl acrylates such as methyladamantyl acrylate and methyladamantylmethacrylate.

Polymers of the invention also may suitably contain multiple types of alicyclic groups, e.g. repeat units that contain a fused alicyclic ring together with repeat units that comprise pendant alicyclic groups.

Unless otherwise indicated, an alicyclic group as referred to herein is inclusive of a group having all carbon ring members as well as groups having one or more hetero atom (e.g. O, S, N or Si, particularly O or S) ring members. A carbon alicyclic group contains all carbon atoms such as e.g. adamantyl, norbornyl, fencyl, pinnanyl, and the like. A heteroalicyclic contains at least one hetero atom (e.g. O, S, N or Si, particularly O or S) ring member. Alicyclic groups are understood not to be aromatic, and as present as a resin component typically are fully saturated within the ring (i.e. no endocyclic multiple bonds), although an alicyclic group may suitably contain one or more endocyclic multiple bonds.

Resins of photoresists of the invention also contain repeat units that contain one or more fluorine atoms. Suitable fluorine substitution may be provided e.g. by polymerization of a compound that contains at least one fluorine atom covalently attached to an ethylenically unsaturated atom, e.g. tetrafluoroethylene, chlorotrifluoroethylene, hexafluoropropylene, trifluoroethylene, vinylidene fluoride, vinyl fluoride, and the like. Additionally, a polymer may contain an alicyclic or other group that has fluoro substitution, such as polymerized fluorohexyl groups and the like.

Photoresists of the invention preferably comprise one or more photoacid generator compounds (PAGs) as a photoactive component. Preferred PAGs for use in resists of the invention include onium salt compounds including iodonium and sulfonium compounds; and non-ionic PAGs such as imidosulfonate compounds, N-sulfonyloxyimide compounds; diazosulfonyl compounds and other sulfone PAGS including α,α-methylenedisulfones, disulfonehydrazines and disulfonylamine salts; nitrobenzyl compounds, halogenated particularly fluorinated non-ionic PAGS.

Photoresists of the invention also may contain a blend of resins, where at least one of the resins contains fluoro-substituted and alicyclic groups. Preferably each member of the resin blend is a fluorine-containing polymer. Also preferred is that at least one member of the blend is a polymer that contains units derived from polymerization of a compound that contains at least one fluorine atom covalently attached to an ethylenically unsaturated atom, e.g. tetrafluoroethylene.

The invention also includes methods for forming relief images, including methods for forming a highly resolved relief image such as a pattern of lines (dense or isolated) where each line has vertical or essentially vertical sidewalls and a line width of about 0.40 microns or less, or even about 0.25, 0.20, 0.15, or 0.10 microns or less. In such methods, preferably a coating layer of a resist of the invention is imaged with short-wavelength radiation, particularly sub-200 nm radiation, especially 193 and 157 nm radiation, and higher energy radiation having a wavelength of less than 100 nm, and otherwise high energy radiation such as EUV, electron beam, ion beam or x-ray. The invention further comprises articles of manufacture comprising substrates such as a microelectronic wafer having coated thereon the photoresists and relief images of the invention. Other aspects of the invention are disclosed infra.

### DETAILED DESCRIPTION OF THE INVENTION

As discussed above, resists of the invention comprise a resin that contains alicyclic groups and fluorine-substituted groups. The alicyclic groups themselves may be fluoro-substituted, although preferably the resin will contain units other than alicyclic units that have fluoro-substitution, e.g. as provided by polymerization of an unsaturated fluorinated acyclic monomer such as tetrafluoroethylene.

As referred to herein, the term "alicyclic leaving group" of a polymer means the following: an alicyclic group that is covalently bound to a polymer, and when such a polymer is formulated in a photoresist containing the polymer and a photoactive component (particularly one or more photoacid generators), the alicyclic group can be or is cleaved from the polymer (i.e. covalent bond to the polymer cleaved) upon exposure to acid generated upon exposure of a coating layer of the photoresist to activating radiation (e.g. 157 nm or 193 nm), typically with post-exposure thermal treatment (e.g. 90°C, 100°C or 110°C for 0.5, 1 or more minutes).

An alicyclic acrylate compound contains a vinyl ester, where the ester moiety is an alicyclic group such as methyl adamantyl and the like. The vinyl group suitably may be substituted, particularly at the alpha-vinyl carbon such as by C₁₋₈alkyl and thus includes methacrylates.

A fluorinates resin or other material indicates substitution by one or more fluorine atoms at available positions.

As discussed, polymers used in resists of the invention contain an alicyclic leaving group, i.e. the polymer contains photoacid-labile groups where photoacid-induced cleavage thereof removes an alicyclic moiety from the polymer. Thus, for instance, polymers for use in resists of the invention suitably contain polymerized methyladamantyl acrylate groups. Exposure to photogenerated acid and post-exposure thermal treatment results in cleavage of the methyladamantyl moiety from the polymer.

Preferred polymers include those that contain alkyl acrylate units, particularly where the acrylate group contains an alicyclic moiety. Also preferred are polymers that contain a carbon alicyclic group fused to the polymer backbone.

More particularly, preferred polymers for use in resists of the invention comprise structures of the following Formula I: 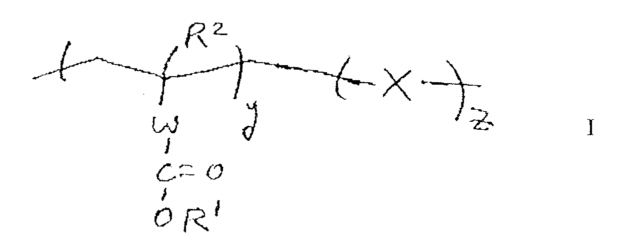 wherein R¹ comprises an alicyclic group, preferably a tertiary alicyclic group such alkyladamantyl, particularly methyladamantyl, ethyladamanty; optionally substituted fencyl; optionally substituted pinanyl; optionally substituted tricyclo decanyl, particularly an alkyl-substituted tricyclo decanyl such as 8-ethyl-8-tricyclodecanyl such as provided by polymerization of 8-ethyl-8-tricyclodecanyl acrylate and 8-ethyl-8-tricyclodecanyl methacrylate; and the like;
W is a linker such as a chemical bond, optionally substituted alkylene group suitably having 1 to about 8 carbon atoms, carbon alicyclic group such as adamantyl, and the like;
R² is hydrogen or optionally substituted alkyl, particularly C₋₈alkyl;
X is a group containing one or more fluorine atoms, particularly as may be provided by polymerization of a fluorinated unsaturated compound, preferably a fluorinated unsaturated compound such as compounds that have at least one fluorine atom covalently attached to an ethylenically unsaturated atom, e.g. tetrafluoroethylene, chlorotrifluoroethylene, hexafluoropropylene, trifluoroethylene, vinylidene fluoride, vinyl fluoride, and the like;
y and z are the mole fractions of the depicted units based on total units in the polymer, and y and z are each greater than zero.

As discussed above, further preferred polymers for use in the photoresists of the invention comprise an alicyclic group, particularly carbon alicyclic groups, fused to the polymer backbone in addition to an alicyclic group that is cleaved from the polymer during lithographic processing (i.e. alicyclic leaving group). Generally preferred are fused carbon alicyclic groups. Particularly preferred polymers include those that comprise a moiety containing an alicyclic leaving group (e.g. a polymerized alicyclic acrylate) and a structure of the following Formula II: 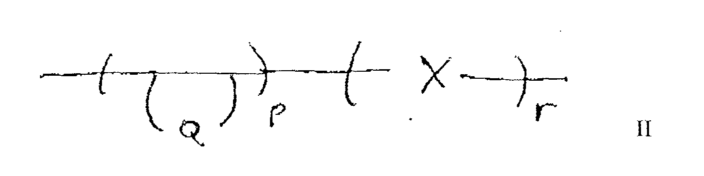 wherein Q represents an optionally substituted carbon alicyclic ring fused to the polymer backbone (i.e. two Q ring members being adjacent carbons of the polymer backbone); the alicyclic ring suitably having from about 5 to about 18 carbon atoms and is suitably a single ring (e.g. cyclopentyl, cyclohexyl or cycloheptyl), or more preferably Q is polycyclic e.g. and contain 2, 3, 4 or more bridged, fused or otherwise linked rings, and preferred substituents of a substituted Q group include photoacid-labile moieties such as a photoacid-labile ester;
X is the same as defined above in Formula I;
p and r are the mole fractions of the depicted units based on total units in the polymer, and p and r are each greater than zero.

Generally preferred structures of Formula II comprise polymerized optionally substituted norbornyl groups, such as a structure of the following Formula III: 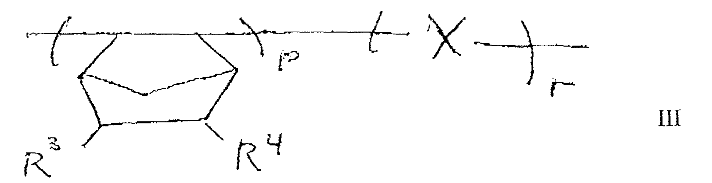 wherein X is the same as defined in Formulae I and II;
R³ and R⁴ are each independently hydrogen or a non-hydrogen substituent such as halo (F, Cl, Br, I), nitro, cyano, optionally substituted alkyl (including cycloalkyl) preferably having from 1 to about 16 carbons; optionally substituted alkoxy preferably having from 1 to about 16 carbons; optionally substituted alkylthio preferably having from 1 to about 16 carbons; optionally substituted carboxy preferably have 1 to about 10 carbon atoms (which includes groups such as -COOR' where R' is H or C₁₋₈alkyl, including esters that are substantially non-reactive with photoacid); a lactone; an anhydride such as an itaconic anhydride group; a photoacid-labile group such as a unprotected or protected alcohol such as hexafluoropropylalcohol or a protected hexafluoropropylalcohol or a photoacid-labile ester, particularly a photoacid-labile ester moiety such as with a tertiary alicyclic group or a non-cyclic group such as t-butyl, an acetal group, a vinyl ether;; and the like,
or R¹ and R² may be taken together to form one or more rings fused to the depicted norbornyl ring;
p and r are the mole fractions of the depicted units based on total units in the polymer, and p and r are each greater than zero.

As discussed above, while polymers that contain carbon alicyclic groups are often preferred for use in resists of the invention, also suitable are polymers that contain heteroalicyclic units, particularly ring structures containing an oxygen or sulfur atom and fused to the polymer backbone. More particularly, preferred for use in photoresists of the invention are polymers that comprise a moiety containing an alicyclic leaving group (e.g. a polymerized alicyclic acrylate) and a structure of the following Formula IV: 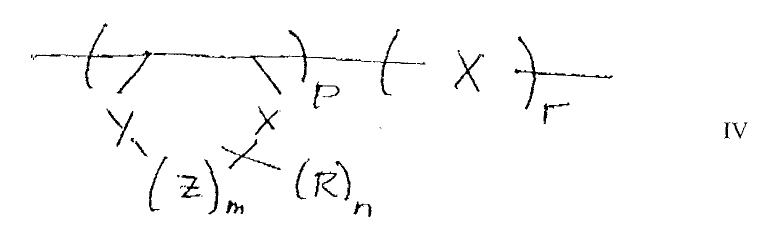 wherein X, Y and Z are each independently carbon, oxygen or sulfur, with at least one of X, Y or Z being oxygen or sulfur, preferably at least one of X, Y and Z being oxygen, and further preferably no more than two of X, Y and Z being other carbon and oxygen and sulfur preferably not being directly adjacent to another hetero ring atom;
each R is the is the same or different non-hydrogen substituent such as cyano; optionally substituted alkyl preferably having I to about 10 carbon atoms; optionally substituted alkanoyl preferably having I to about 10 carbon atoms; optionally substituted alkoxy preferably having 1 to about 10 carbon atoms; optionally substituted alkylthio preferably having 1 to about 10 carbon atoms; optionally substituted alkylsulfinyl preferably 1 to about 10 carbon atoms; optionally substituted alkylsulfonyl preferably having 1 to about 10 carbon atoms; optionally substituted carboxy preferably having 1 to about 10 carbon atoms (which includes groups such as -COOR' where R' is H or C₁₋₈alkyl, including esters that are substantially non-reactive with photoacid); a photoacid-labile group such as a photoacid-labile ester e.g. a tert-butyl ester, an alicyclic ester particularly a tertiary alicyclic ester, an acetal group, a vinyl ether; and the like; etc.
m is 1 (to provide a fused five-membered ring), 2 (to provide a fused six-membered ring), 3 (to provide a fused seven-membered ring), or 4 (to provide a fused eight-membered ring);
X is a group containing one or more fluorine atoms, particularly as may be provided by polymerization of a fluorinated unsaturated compound, preferably a fluorinated unsaturated compound such as compounds that have at least one fluorine atom covalently attached to an ethylenically unsaturated atom, e.g. tetrafluoroethylene, chlorotrifluoroethylene, hexafluoropropylene, trifluoroethylene, vinylidene fluoride, vinyl fluoride, and the like;
p and r are the mole fractions of the depicted units based on total units in the polymer, and p and r are each greater than zero.

Preferred fluorine-containing units of polymers used in resists of the invention are suitably derived from at least one ethylenically unsaturated compound. The unsaturated group may be an alicyclic group such as norbornene, cyclohexene, adamantene and the like. The alicyclic unsaturated compound preferably has one or more substituents of fluorine, perfluoroalkyl particularly C₁₋₁₂perfluoralkyl, or perfluoroalkoxy particularly C₁₋₁₂ perfluoralkoxy. Preferably, such a fluorine substituent is separated from the unsaturated carbons by at least one saturated carbon in order to not unduly inhibit the polymerization reaction. Also preferred are fluorinated olefinic compounds such as tetrafluoroethylene (TFE) compounds and hexafluoroisopropanol compounds and derivatives thereof. Exemplary preferred unsaturated compounds for synthesis of polymers utilized in resists of the invention include the following of Formulae (A), (B), (C) and (D): 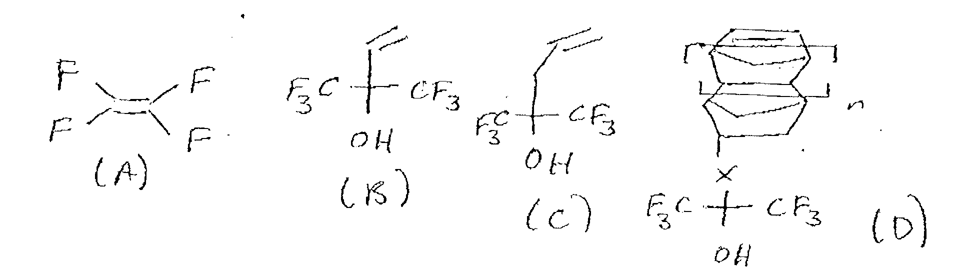 wherein in Formulae (D), X is a linker, preferably -CH₂-, -CH₂OCH₂-, or -OCH₂-; and n is 0 or 1.

Additional preferred monomers for use in a polymer of a resist of the invention may comprise a group of the following formula: 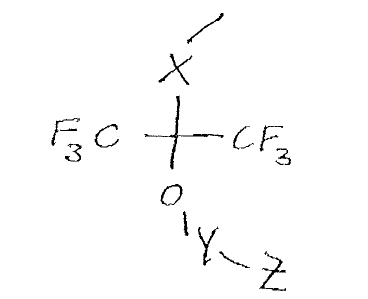 wherein X is a linker, preferably -CH₂-, -CH₂OCH₂-, or -OCH₂-
Y is hydrogen, a chemical bond linking the oxygen and group Z, (-CH₂-)p where p is 1 or 2, -CH₂O-, or CHRO- where R is C₁₋₁₆alkyl, preferably C₁₋₄alkyl; and
Z is alkyl preferably having 1 to about 20 carbon s and including tri(C₁₋₁₆) alkylmethyl; di(C₁₋₁₆)alkylcarboxylicarylmethyl; benzyl; fenchyl; tri(C₁₋₁₆ alkyl)carbocyclicaryl; C₁₋₁₆alkylcarbonyloxy; a formyl group; an acetate group such as having 2 to about 20 carbon atoms; tetrahydropyranyl; or tetrahydrofuranyl;
and preferably X is -OCH₂-; preferably Y is a bond or -CH₂O-; and preferably Z is t-butyl, methyl or fenchyl.

Polymers used in resists of the invention, including polymers comprising a structure of the above Formulae I, II, III, and/or IV, also may contain additional units such as nitrile units e.g. as provided by polymerization of methacrylonitrile and acrylonitrile; additional contrast enhancing groups also may be present in polymers of the invention, such as groups provided by polymermization of methacrylic acid, acrylic acid, and such acids protected as photoacid labile esters, e.g. as provided by reaction of ethoxyethyl methacrylate, t-butoxy methacrylate, t-butylmethacrylate and the like. Polymers used in resists of the invention also may contain lactone and anhydride units, e.g. as provided by polymerization of maleic anhydride

Preferred polymers of the invention contain 3, 4 or 5 distinct repeat units, i.e. preferred are terpolymers, tetrapolymers and pentapolymers that contain one or more alicyclic groups as disclosed herein.

Polymers of the invention are preferably employed in photoresists imaged at 193 nm, and thus preferably will be substantially free of any phenyl or other aromatic groups. For example, preferred polymers contain less than about 5 mole percent aromatic groups, more preferably less than about 1 or 2 mole percent aromatic groups, more preferably less than about 0.1, 0.02, 0.04 and 0.08 mole percent aromatic groups and still more preferably less than about 0.01 mole percent aromatic groups. Particularly preferred polymers are completely free of aromatic groups. Aromatic groups can be highly absorbing of sub-200 nm radiation and thus are undesirable for polymers used in photoresists imaged with such short wavelength radiation.

Preferred polymers of the invention will contain at least about 2 to 5 mole percent of alicyclic units based on total units of the polymer; more preferably from about 5 to 50, 60, 70 or 80 mole percent of alicyclic units based on total units of the polymer.

As discussed above, preferred photoacid-labile groups of polymers of the invention include photoacid-labile ester groups are often preferred such as a tert-butyl ester, or an ester containing a tertiary alicyclic group. Such photoacid-labile esters may be directly pendant from a carbon alicyclic, heteroalicyclic or other polymer unit (e.g. where the photoacid-labile group is of the formula -C(=O)OR, where R is tert-butyl or other non-cyclic alkyl group, or a tertiary alicyclic group and is directly linked to the polymer unit), or the ester moieties may be spaced from the from a heteroalicyclic or carbon alicyclic polymer unit, e.g. by an optionally alkylene linkage (e.g. -(CH₂)₁₋₈ C(=O)OR, where R is tert-butyl or other non-cyclic alkyl group, or a tertiary alicyclic group). Such photoacid-labile groups also suitably may be contain fluorine substitution at available positions.

In any event, polymers of the invention preferably comprise contain one or more repeat units that comprise a photoacid-labile group. As discussed with respect to substituents R, R³, and R⁴ of the above Formulae I through IV, the photoacid-labile moiety may be a substituent of a heteroalicyclic or carbon alicyclic ring member. Alternatively, and often preferred, the photoacid-labile moiety will be a polymer repeat unit distinct from repeat units containing a heteroalicyclic or carbon alicyclic group.

As discussed, preferred photoacid-labile ester groups contain a tertiary alicyclic hydrocarbon ester moiety. Preferred tertiary alicyclic hydrocarbon ester moieties are polycyclic groups such adamantyl, ethylfencyl or a tricyclo decanyl moiety. References herein to a "tertiary alicyclic ester group" or other similar term indicate that a tertiary alicyclic ring carbon is covalently linked to the ester oxygen, i.e.-C(=O)O-TR' where T is a tertiary ring carbon of alicyclic group R'. In at least many cases, preferably a tertiary ring carbon of the alicyclic moiety will be covalently linked to the ester oxygen, such as exemplified by the below-depicted specifically preferred polymers. However, the tertiary carbon linked to the ester oxygen also can be exocyclic to the alicyclic ring, typically where the alicyclic ring is one of the substituents of the exocyclic tertiary carbon. Typically, the tertiary carbon linked to the ester oxygen will be substituted by the alicyclic ring itself, and/or one, two or three alkyl groups having 1 to about 12 carbons, more typically 1 to about 8 carbons, even more typically 1, 2, 3 or 4 carbons. The alicyclic group also preferably will not contain aromatic substitution. The alicyclic groups may be suitably monocyclic, or polycyclic, particularly bicyclic or tricyclic groups.

Preferred alicyclic moieties (e.g. group TR' of -C(=O)O-TR') of photoacid labile ester groups of polymers of the invention have rather large volume. It has been found that such bulky alicyclic groups can provide enhanced resolution when used in copolymers of the invention.

More particularly, preferred alicyclic groups of photoacid labile ester groups will have a molecular volume of at least about 125 or about 130 Å³, more preferably a molecular volume of at least about 135, 140, 150, 155, 160, 165, 170, 175, 180, 185, 190, 195, or 200 Å³. Alicyclic groups larger than about 220 or 250 Å³ may be less preferred, in at least some applications. References herein to molecular volumes designate volumetric size as determined by standard computer modeling, which provides optimized chemical bond lengths and angles. A preferred computer program for determining molecular volume as referred to herein is Alchemy 2000, available from Tripos. For a further discussion of computer-based determination of molecular size, see T Omote et al, *Polymers for Advanced Technologies,* volume 4, pp. 277-287.

Particularly preferred tertiary alicyclic groups of photoacid-labile units include the following, where the wavy line depicts a bond to the carboxyl oxygen of the ester group, and R is suitably optionally substituted alkyl, particularly C₁₋₈ alkyl such as methyl, ethyl, etc.

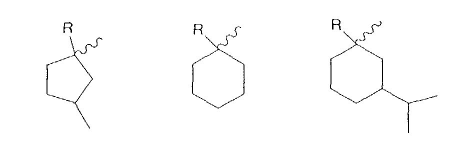

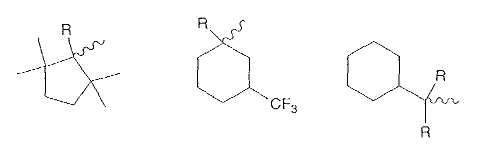

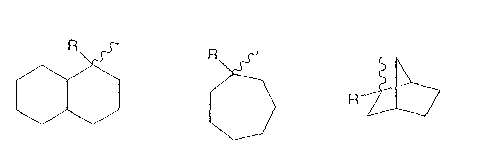

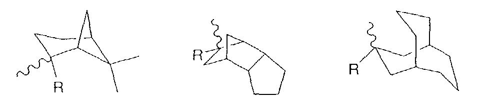

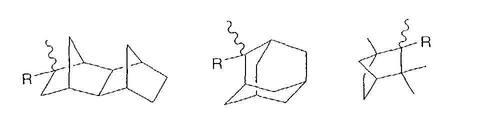

Polymers of the invention also may contain photoacid-labile groups that do not contain an alicyclic moiety. For example, polymers of the invention may contain photoacid-labile ester units, such as a photoacid-labile alkyl ester. Generally, the carboxyl oxygen (i.e. the carboxyl oxygen as underlined as follows: -C(=O)O) of the photoacid-labile ester will be covalently linked to the quaternary carbon. Branched photoacid-labile esters are generally preferred such as t-butyl and -C(CH₃)₂CH(CH₃)₂.

In this regard, polymers used in resists of the invention may contain distinct photoacid-labile groups, i.e. the polymer may contain two or more ester groups that have distinct ester moiety substitutions e.g. one ester may have an alicyclic moiety and another ester may have an acyclic moiety such as t-butyl, or the polymer may contain both ester and other functional groups that are photoacid-labile such as acetals, ketals and/or ethers.

Polymers of the invention also may contain additional units such as cyano units, lactone units or anhydride units. For example, acrylonitrile or methacrylonitrile may be polymerized to provide pendant cyano groups, or maleic anhydride may be polymerized to provide a fused anhydride unit.

Especially preferred polymers for use in resists of the invention include those that are provided by polymerization of a fluorinated ethylenic monomer such as tetrafluoroethylene; an acrylate preferably with a tertiary alicyclic ester group such as methyladamantyl acrylate or methyladamantyl methacrylate; and an optionally substituted carbon alicyclic olefin or optionally substituted heteroalicyclic olefin such as polymerized optionally substituted norbornene groups.

As discussed, various moieties may be optionally substituted, including groups of Formulae I, II, III, and IV. A "substituted" substituent may be substituted at one or more available positions, typically 1, 2, or 3 positions by one or more suitable groups such as e.g. halogen (particularly F, Cl or Br); cyano; C₁₋₈ alkyl; C₁₋₈ alkoxy; C₁₋₈ alkylthio; C₁₋₈ alkylsulfonyl; C₂₋₈ alkenyl; C₂₋₈ alkynyl; hydroxyl; nitro; alkanoyl such as a C₁₋₆ alkanoyl e.g. acyl and the like; etc.

Preferred alkanoyl groups, including as specified in the above formulae, will have one or more keto groups, such as groups of the formula -C(=O)R" where R" is hydrogen or C₁₋₈ alkyl. Suitable lactone groups, including as specified in the above formulae, include alpha-butyrolactone groups and the like.

Polymers of the invention can be prepared by a variety of methods. One suitable method is an addition reaction which may include free radical polymerization, e.g., by reaction of selected monomers to provide the various units as discussed above in the presence of a radical initiator under an inert atmosphere (e.g., N₂ or argon) and at elevated temperatures such as about 70°C or greater, although reaction temperatures may vary depending on the reactivity of the particular reagents employed and the boiling point of the reaction solvent (if a solvent is employed). Suitable reaction solvents include e.g. tetrahydrofuran or more suitably a halogenated solvent such as a fluorinated solvent or a chlorinated solvent and the like. Suitable reaction temperatures for any particular system can be readily determined empirically by those skilled in the art based on the present disclosure. A variety of free radical initiators may be employed. For example, azo compounds may be employed such as azo-bis-2,4-dimethylpentanenitrile. Peroxides, peresters, peracids and persulfates also could be employed.

Other monomers that can be reacted to provide a polymer of the invention can be identified by those skilled in the art. For example, to provide photoacid-labile units, suitable monomers include e.g. methacrylate or acrylate that contains the appropriate group substitution (e.g. tertiary alicyclic, t-butyl, etc.) on the carboxy oxygen of the ester group. Suitable acrylate monomers with tertiary alicyclic groups for synthesis of polymers useful in the resists of the invention also are disclosed in U.S. Patent 6,306,554 to Barclay et al. Maleic anhydride is a preferred reagent to provide fused anhydride polymer units. Vinyl lactones are also preferred reagents, such as alpha-butyrolactone.

Some suitable vinyl (endocyclic double bond) heterocyclic monomers that can be polymerized to provide polymers of the invention include the following:

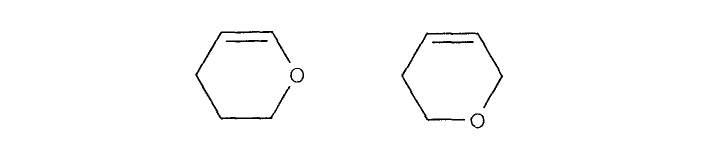

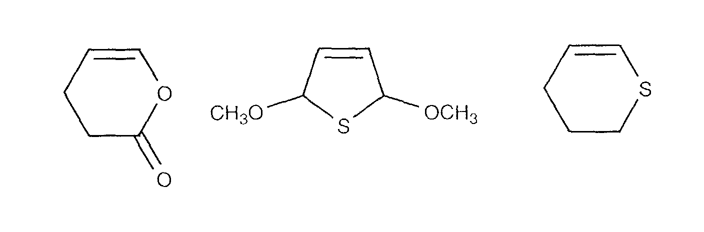

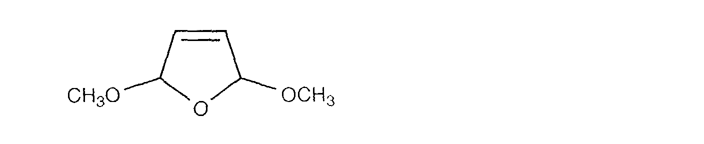

Preferably a polymer of the invention will have a weight average molecular weight (Mw) of about 800 or 1,000 to about 100,000, more preferably about 2,000 to about 30,000, still more preferably from about 2,000 to 15,000 or 20,000, with a molecular weight distribution (Mw/Mn) of about 3 or less, more preferably a molecular weight distribution of about 2 or less. Molecular weights (either Mw or Mn) of the polymers of the invention are suitably determined by gel permeation chromatography.

Polymers of the invention used in chemically-amplified positive-acting photoresist formulations should contain a sufficient amount of photogenerated acid labile ester groups to enable formation of resist relief images as desired. For instance, suitable amount of such acid labile ester groups will be at least 1 mole percent of total units of the polymer, more preferably about 2 to 7 mole percent, still more typically about 3 to 30, 40, 50 or 60 mole percent of total polymer units. See Example 1 which follows for an exemplary preferred polymer.

As discussed above, the polymers of the invention are highly useful as a resin binder component in photoresist compositions, particularly chemically-amplified positive resists. Photoresists of the invention in general comprise a photoactive component and a resin binder component that comprises a polymer as described above.

The resin binder component should be used in an amount sufficient to render a coating layer of the resist developable with an aqueous alkaline developer.

The resist compositions of the invention also comprise a photoacid generator (i.e. "PAG") that is suitably employed in an amount sufficient to generate a latent image in a coating layer of the resist upon exposure to activating radiation. Preferred PAGs for imaging at 193 nm and 248 nm imaging include imidosulfonates such as compounds of the following formula: 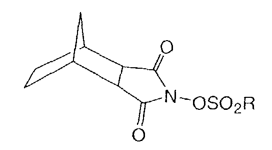 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs, particularly sulfonate salts. Two suitable agents for 193 nm and 248 nm imaging are the following PAGS 1 and 2:

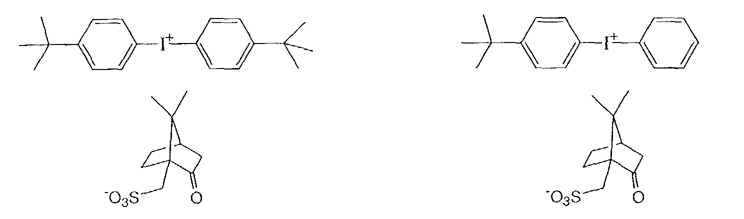

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Also preferred is a triphenyl sulfonium PAG, complexed with anions such as the sulfonate anions mentioned above, particularly a perfluoroalkyl sulfonate such as perfluorobutane sulfonate.

Other known PAGS also may be employed in the resists of the invention. Particularly for 193 nm imaging, generally preferred are PAGS that do not contain aromatic groups, such as the above-mentioned imidosulfonates, in order to provide enhanced transparency.

A preferred optional additive of resists of the invention is an added base, particularly tetrabutylammonium hydroxide (TBAH), or tetrabutylammonium lactate, which can enhance resolution of a developed resist relief image. For resists imaged at 193 nm, a preferred added base is a lactate salt of tetrabutylammonium hydroxide as well as various other amines such as triisopropanol, diazabicyclo undecene or diazabicyclononene. The added base is suitably used in relatively small amounts, e.g. about 0.03 to 5 percent by weight relative to the total solids.

Photoresists of the invention also may contain other optional materials. For example, other optional additives include anti-striation agents, plasticizers, speed enhancers, etc. Such optional additives typically will be present in minor concentrations in a photoresist composition except for fillers and dyes which may be present in relatively large concentrations, e.g., in amounts of from about 5 to 30 percent by weight of the total weight of a resist's dry components.

The resists of the invention can be readily prepared by those skilled in the art. For example, a photoresist composition of the invention can be prepared by dissolving the components of the photoresist in a suitable solvent such as, for example, 2-heptanone, cyclohexanone, ethyl lactate, ethylene glycol monomethyl ether, ethylene glycol monomethyl ether acetate, propylene glycol monomethyl ether; propylene glycol monomethyl ether acetate and 3-ethoxyethyl propionate. Typically, the solids content of the composition varies between about 5 and 35 percent by weight of the total weight of the photoresist composition. The resin binder and photoactive components should be present in amounts sufficient to provide a film coating layer and formation of good quality latent and relief images. See the examples which follow for exemplary preferred amounts of resist components.

The compositions of the invention are used in accordance with generally known procedures. The liquid coating compositions of the invention are applied to a substrate such as by spinning, dipping, roller coating or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon wafers or silicon wafers coated with silicon dioxide for the production of microprocessors and other integrated circuit components. Aluminum-aluminum oxide, gallium arsenide, ceramic, quartz, copper, glass substrates and the like are also suitably employed.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, the exposure energy typically ranges from about 1 to 100 mJ/cm², dependent upon the exposure tool and the components of the photoresist composition.

As discussed above, coating layers of the resist compositions of the invention are preferably photoactivated by a short exposure wavelength, particularly a sub-300 and sub-200 nm exposure wavelength. As discussed above, 193 nm is a particularly preferred exposure wavelength. 157 nm also is a preferred exposure wavelength. However, the resist compositions of the invention also may be suitably imaged at higher wavelengths. For example, a resin of the invention can be formulated with an appropriate PAG and sensitizer if needed and imaged at higher wavelengths e.g. 248 nm or 365 nm.

Following exposure, the film layer of the composition is preferably baked at temperatures ranging from about 70°C to about 160°C. Thereafter, the film is developed. The exposed resist film is rendered positive working by employing a polar developer, preferably an aqueous based developer such as quaternary ammonium hydroxide solutions such as a tetra-alkyl ammonium hydroxide solution; various amine solutions preferably a 0.26 N tetramethylammonium hydroxide, such as ethyl amine, n-propyl amine, diethyl amine, di-n-propyl amine, triethyl amine, or methyldiethyl amine; alcohol amines such as diethanol amine or triethanol amine; cyclic amines such as pyrrole, pyridine, etc. In general, development is in accordance with procedures recognized in the art.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a halogen plasma etchant such as a chlorine or fluorine-based etchant such a Cl₂ or CF₄/CHF₃ etchant applied as a plasma stream. After such processing, resist may be removed from the processed substrate using known stripping procedures.

All documents mentioned herein are incorporated herein by reference. The following non-limiting examples are illustrative of the invention.

### Example 1: Polymer synthesis

A polymer was prepared by reaction of 1) norbornene having a ring substituent of -OCH₂C(CF₃)₂; 2) tetrefluorethylene (TFE); and 3) methyladamantyl acrylate.

The resulting polymer contained units of the substituted norbornene in an amount of 39 mole percent based on total polymer units, tetrafluoroethylene units in an amount of 13 mole percent based on total polymer units, and methyladamantyl acrylate units in an amount of about 47 mole percent based on total polymer units.

The resulting polymer had an Mw of 9,334; an Mn of 6,614; a polydispersity of 1.41; a Tg of 148°C; Td of 196°C; and an Abs/um of 0.14 at 193 nm.

### Example 2: Preparation of a resist of the invention.

A resist of the invention was prepared by admixing the following components where amounts are expressed as weight percent of solids (all components except solvent) and the resist is formulated as an 85 weight percent fluid formulation:

| Component | Amount |
|---|---|
| Resin | balance |
| PAG | 5 |
| Basic Additive | 0.3 |
| Surfactant | 0.1 |
| Solvent | to 85 percent formulation |

In the resist, the resin was the polymer prepared n Example 1. The PAG was triphenylsulfonium perfluorobutane sulfonate. The basic additive was tetrabutylammonium lactate. The surfactant was R08. The solvent was a 70:30 v/v mixture of 2-heptanone:ethyl lactate.

The formulated resist composition was spin coated onto HMDS vapor primed 4 inch silicon wafers and softbaked via a vacuum hotplate at 120°C for 90 seconds. The resist coating layer was exposed through a photomask at 193 nm, and then the exposed coating layers were post-exposure baked at 100°C. The imaged resist layer is then developed by treatment with an aqueous tetramethylammonium hydroxide solution to provide a relief image.

### Example 3: Preparation of a resist of the invention.

A further resist of the invention was prepared by admixing the following components where amounts are expressed as weight percent of solids (all components except solvent) and the resist is formulated as an 85 weight percent fluid formulation:

| Component | Amount |
|---|---|
| Resin | balance |
| PAG | 3.5 |
| Basic Additive | 0.4 |
| Surfactant | 0.1 |
| Solvent | to 85 percent formulation |

In the resist, the resin was the polymer prepared n Example 1. The PAG was triphenylsulfonium perfluorobutane sulfonate. The basic additive was tetrabutylammonium lactate. The surfactant was R08. The solvent was a 70:30 v/v mixture of 2-heptanone:ethyl lactate.

The formulated resist composition was spin coated onto HMDS vapor primed 4 inch silicon wafers and softbaked via a vacuum hotplate at 120°C for 90 seconds. The resist coating layer was exposed through a photomask at 193 nm, and then the exposed coating layers were post-exposure baked at 100°C. The imaged resist layer is then developed by treatment with an aqueous tetramethylammonium hydroxide solution to provide a relief image.

The foregoing description of the invention is merely illustrative thereof, and it is understood that variations and modifications can be effected without departing from the spirit or scope of the invention as set forth in the following claims.
The preferred embodiments of the invention include the following (numbered sentences 1-70, and where many of the sentences refer back to and thereby incorporate by reference previous numbered sentences):
1. A method for providing a photoresist relief image, comprising:
   a) applying a coating layer of a photoresist composition on a substrate, the photoresist composition comprising a photoactive component and a fluorinated resin that comprises an alicyclic leaving group; and
   b) exposing the photoresist composition layer to activating radiation and developing the exposed photoresist composition coating layer.
2. The method of 1 above wherein the resin comprises photoacid-labile ester groups.
3. The method of 1 or 2 above wherein the resin comprises photoacid-labile acetal, ketal or ether groups.
4. The method of any one of 1 through 3 above wherein the resin comprises acrylate units.
5. The method of 4 above wherein the acrylate units comprises an alicyclic group.
6. The method of 5 above wherein the acrylate units comprise a tertiary alicyclic group.
7. The method of any one of 1 through 6 above wherein the resin comprises an alicyclic group fused to the resin backbone.
8. The method of 7 above wherein the alicyclic group is a carbon alicyclic group.
9. The method of 7 above wherein the alicyclic group is a heteroalicyclic group.
10. The method of 7 above wherein the alicyclic group is a heteroalicyclic group that comprises at least one ring oxygen.
11. The method of any one of 1 through 10 above wherein the resin comprises units provided by polymerization of a compound that contains at least one fluorine atom covalently attached to an ethylenically unsaturated atom.
12. The method of any one of 1 through 10 above wherein the resin comprises units provided by polymerization of tetrafluoroethylene, chlorotrifluoroethylene, hexafluoropropylene, trifluoroethylene, vinylidene fluoride, and/or vinyl fluoride.
13. The method of any one of 1 through 10 above wherein the resin comprises units provided by polymerization of tetrafluoroethylene.
14. The method of 1 above wherein the resin comprises a structure of Formula I: 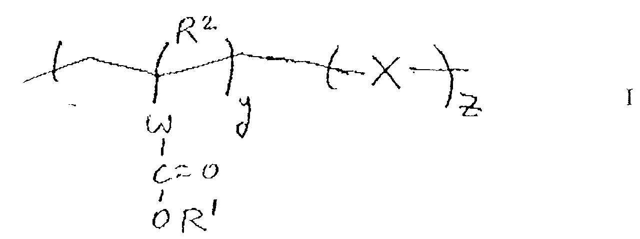 wherein R¹ comprises an alicyclic group;;
   W is a linker;
   R² is hydrogen or optionally substituted alkyl;
   X is a group containing one or more fluorine atoms; and
   y and z are the mole fractions of the respective units in the resin and are each greater than zero.
15. The method of 1 above wherein the resin comprises a structure of Formula II: 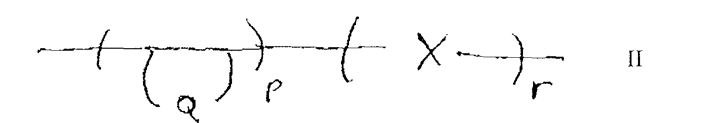 wherein Q represents an optionally substituted carbon alicyclic ring fused to the polymer backbone;
   X is a group containing one or more fluorine atoms;
   p and r are the mole fractions of the respective units in the resin and are each greater than zero.
16. The method of 1 above wherein the resin comprises a structure of Formula III: 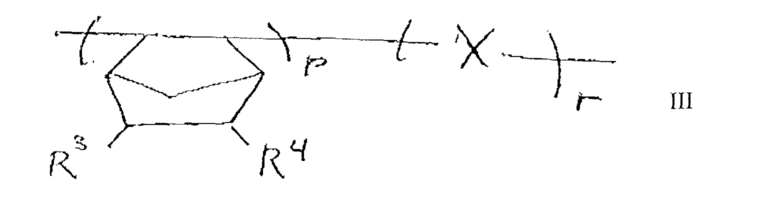 wherein X is a group containing one or more fluorine atoms;
   R³ and R⁴ are each independently hydrogen or a non-hydrogen substituents; and
   p and r are the mole fractions of the respective units and are each greater than zero.
17. The method of 1 above wherein the resin comprises a structure of the following Formula IV: 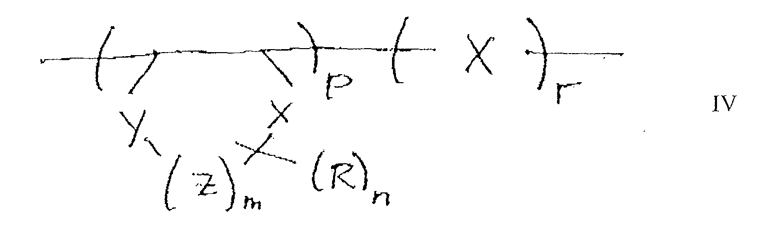 wherein X, Y and Z are each independently carbon, oxygen or sulfur, with at least one of X, Y or Z being oxygen or sulfur;
   each R is the is the same or different non-hydrogen substituents;
   m is 1, 2, 3 or 4;
   X is a group containing one or more fluorine atoms;
   p and r are the mole fractions of the respective units and are each greater than zero.
18. The method of any one of 1 through 17 above wherein the resin is substantially free of aromatic groups.
19. The method of any one of 1 through 18 above wherein the resin is completely free of aromatic groups.
20. The method of any one of 1 through 19 above wherein the photoresist comprises one or more photoacid generator compounds.
21. The method of any one of 1 through 20 above wherein the photoresist composition coating layer is exposed to radiation having a wavelength of less than about 200 nm.
22. The method of any one of 1 through 20 above wherein the photoresist composition coating layer is exposed to radiation having a wavelength of about 193 nm.
23. The method of any one of 1 through 20 above wherein the photoresist composition coating layer is exposed to radiation having a wavelength of about 157 nm.
24. A method for providing a photoresist relief image, comprising:
   a) applying a coating layer of a photoresist composition on a substrate, the photoresist composition comprising a photoactive compound and a fluorinated resin comprising a polymerized alicyclic acrylate compound; and
   b) exposing the photoresist composition layer to activating radiation and developing the exposed photoresist composition coating layer.
25. The method of 24 above wherein the resin comprises tertiary alicyclic units.
26. The method of 24 or 25 above wherein the resin comprises an alicyclic group fused to the resin backbone.
27. The method of 26 above wherein the alicyclic group is a carbon alicyclic group.
28. The method of 26 above wherein the alicyclic group is a heteroalicyclic group.
29. The method of 26 above wherein the alicyclic group is a heteroalicyclic group that comprises at least one ring oxygen.
30. The method of any one of 24 through 29 above wherein the resin comprises units provided by polymerization of a compound that contains at least one fluorine atom covalently attached to an ethylenically unsaturated atom.
31. The method of any one of 24 through 29 above wherein the resin comprises units provided by polymerization of tetrafluoroethylene, chlorotrifluoroethylene, hexafluoropropylene, trifluoroethylene, vinylidene fluoride, or vinyl fluoride.
32. The method of any one of 24 through 29 above wherein the resin comprises units provided by polymerization of tetrafluoroethylene.
33. A method of any one of 24 through 32 above wherein the resin is substantially free of aromatic groups.
34. A method of any one of 24 through 32 above wherein the resin is completely free of aromatic groups.
35. The method of any one of 24 through 34 above wherein the photoresist composition coating layer is exposed to radiation having a wavelength of less than about 200 nm.
36. The method of any one of 24 through 34 above wherein the photoresist composition coating layer is exposed to radiation having a wavelength of about 193 nm.
37. The method of any one of 24 through 34 above wherein the photoresist composition coating layer is exposed to radiation having a wavelength of about 157 nm.
38. A photoresist comprising:
   a fluorinated resin and a photoactive component, the resin comprising an alicyclic leaving group.
39. The photoresist of 38 above wherein the resin comprises photoacid-labile ester groups.
40. The photoresist of 38 or 39 above wherein the resin comprises photoacid-labile acetal, ketal or ether groups.
41. The photoresist of any one of 38 through 40 above wherein the resin comprises acrylate units.
42. The photoresist of 41 above wherein the acrylate units comprise an alicyclic group.
43. The photoresist of 42 above wherein the acrylate units comprise a tertiary alicyclic group.
44. The photoresist of any one of 38 through 43 above wherein the resin comprises an alicyclic group fused to the resin backbone.
45. The photoresist of 44 above wherein the alicyclic group is a carbon alicyclic group.
46. The photoresist of 44 above wherein the alicyclic group is a heteroalicyclic group.
47. The photoresist of 44 above wherein the alicyclic group is a heteroalicyclic group that comprises at least one ring oxygen.
48. The photoresist of any one of 38 through 47 above wherein the resin comprises units provided by polymerization of a compound that contains at least one fluorine atom covalently attached to an ethylenically unsaturated atom.
49. The photoresist of any one of 38 through 48 above wherein the resin comprises units provided by polymerization of tetrafluoroethylene, chlorotrifluoroethylene, hexafluoropropylene, trifluoroethylene, vinylidene fluoride, and/or vinyl fluoride.
50. The photoresist of any one of 38 through 48 above wherein the resin comprises units provided by polymerization of tetrafluoroethylene.
51. The photoresist of 38 above wherein the resin comprises a structure of Formula I: 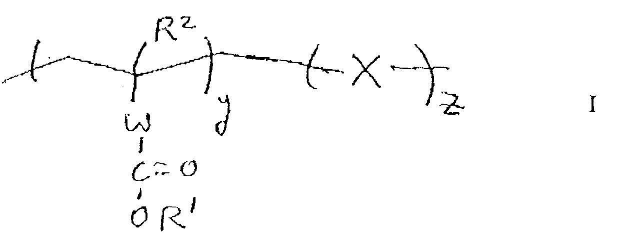 wherein R¹ comprises an alicyclic group;;
   W is a linker;
   R² is hydrogen or optionally substituted alkyl;
   X is a group containing one or more fluorine atoms; and
   y and z are the mole fractions of the respective units in the resin and are each greater than zero.
52. The photoresist of 38 above wherein the resin comprises a structure of Formula II: 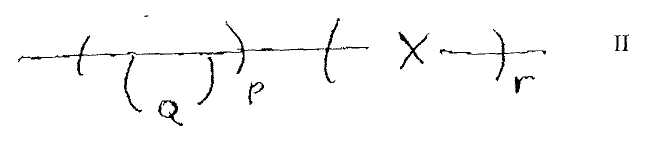 wherein Q represents an optionally substituted carbon alicyclic ring fused to the polymer backbone;
   X is a group containing one or more fluorine atoms;
   p and r are the mole fractions of the respective units in the resin and are each greater than zero.
53. The photoresist of 38 above wherein the resin comprises a structure of Formula III: 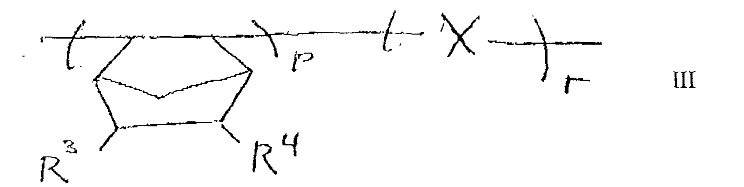 wherein X is a group containing one or more fluorine atoms;
   R³ and R⁴ are each independently hydrogen or a non-hydrogen substituents; and
   p and r are the mole fractions of the respective units and are each greater than zero.
54. The photoresist of 38 above wherein the resin comprises a structure of the following Formula IV: 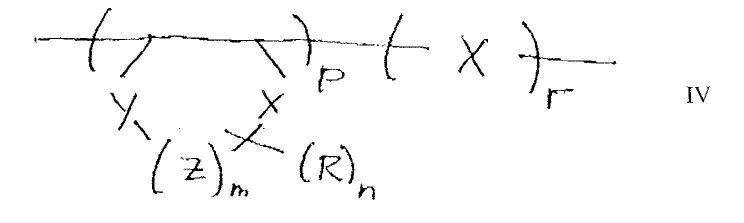 wherein X, Y and Z are each independently carbon, oxygen or sulfur, with at least one of X, Y or Z being oxygen or sulfur;
   each R is the is the same or different non-hydrogen substituents;
   m is 1, 2, 3 or 4;
   X is a group containing one or more fluorine atoms;
   p and r are the mole fractions of the respective units and are each greater than zero.
55. The photoresist of any one of 38 through 54 above wherein the resin is substantially free of aromatic groups.
56. The photoresist of any one of 38 through 54 above wherein the resin is completely free of aromatic groups.
57. The photoresist of any one of 38 through 56 above wherein the photoresist comprises one or more photoacid generator compounds.
58. A photoresist composition comprising a photoactive compound and a fluorinated resin that comprises a polymerized alicyclic acrylate compound.
59. The photoresist of 58 above wherein the resin comprises tertiary alicyclic units.
60. The photoresist of 58 or 59 above wherein the resin comprises an alicyclic group fused to the resin backbone.
61. The photoresist of 60 above wherein the alicyclic group is a carbon alicyclic group.
62. The photoresist of 60 above wherein the alicyclic group is a heteroalicyclic group.
63. The photoresist of 60 above wherein the alicyclic group is a heteroalicyclic group that comprises at least one ring oxygen.
64. The photoresist of any one of 58 through 63 above wherein the resin comprises units provided by polymerization of a compound that contains at least one fluorine atom covalently attached to an ethylenically unsaturated atom.
65. The photoresist of any one of 58 through 63 above wherein the resin comprises units provided by polymerization of tetrafluoroethylene, chlorotrifluoroethylene, hexafluoropropylene, trifluoroethylene, vinylidene fluoride, or vinyl fluoride.
66. The photoresist of any one of 58 through 63 above wherein the resin comprises units provided by polymerization of tetrafluoroethylene.
67. The photoresist of any one of 58 through 66 above wherein the resin is substantially free of aromatic groups.
68. The photoresist of any one of 58 through 66 above wherein the resin is completely free of aromatic groups.
69. An article of manufacture comprising a substrate having coated thereon a photoresist of any one of 38 through 68 above.
70. The article of 69 above wherein the substrate is a microelectronic wafer.

## Claims

1. A method for providing a photoresist relief image, comprising:
a) applying a coating layer of a photoresist composition on a substrate, the photoresist composition comprising a photoactive component and a fluorinated resin that comprises an alicyclic leaving group; and
b) exposing the photoresist composition layer to activating radiation and developing the exposed photoresist composition coating layer.

2. The method of claim 1 wherein the resin comprises photoacid-labile ester groups and/or photoacid-labile acetal, ketal or ether groups.

3. The method of claim 1 or 2 wherein the resin comprises acrylate units, preferably the acrylate units comprising an alicyclic group, more preferably a tertiary alicyclic group.

4. The method of any one of claims 1 through 3 wherein the resin comprises an alicyclic group fused to the resin backbone.

5. The method of any one of claims 1 through 14 wherein the resin comprises units provided by polymerization of a compound that contains at least one fluorine atom covalently attached to an ethylenically unsaturated atom, such as provided by polymerization of tetrafluoroethylene, chlorotrifluoroethylene, hexafluoropropylene, trifluoroethylene, vinylidene fluoride, and/or vinyl fluoride.

6. The method of any one of claims 1 through 5 wherein the resin is substantially free of aromatic groups.

7. The method of any one of claims I through 6 wherein the photoresist composition coating layer is exposed to radiation having a wavelength of less than about 200 nm.

8. The method of any one of claims 1 through 7 wherein the photoresist composition coating layer is exposed to radiation having a wavelength of about 193 nm or 157 nm.

9. A photoresist comprising:
a fluorinated resin and a photoactive component, the resin comprising an alicyclic leaving group.

10. An article of manufacture comprising a substrate having coated thereon a photoresist of claim 9.
